Europäisches Patentamt

European Patent Office

Office européen des brevets

Numéro de publication: **0 274 941**

**A1**

## DEMANDE DE BREVET EUROPEEN

Numéro de dépôt: **87402816.0**

Date de dépôt: **11.12.87**

Int. Cl.⁴ **H01L 23/56**

Priorité: **16.12.86 FR 8617564**

Date de publication de la demande:
**20.07.88 Bulletin 88/29**

Etats contractants désignés:
**DE GB NL**

Demandeur: **THOMSON HYBRIDES ET MICROONDES**
**173, bld Haussmann**
**F-75008 Paris(FR)**

Inventeur: **Derewonko, Henri**
**THOMSON-CSF SCPI 19, avenue de Messine**
**F-75008 Paris(FR)**
Inventeur: **Delagebeaudeuf, Daniel**
**THOMSON-CSF SCPI 19, avenue de Messine**
**F-75008 Paris(FR)**
Inventeur: **Adam, Didier**
**THOMSON-CSF SCPI 19, avenue de Messine**
**F-75008 Paris(FR)**
Inventeur: **Resneau, Patrick**
**THOMSON-CSF SCPI 19, avenue de Messine**
**F-75008 Paris(FR)**

Mandataire: **Taboureau, James et al**
**THOMSON-CSF SCPI 19, avenue de Messine**
**F-75008 Paris(FR)**

**Dispositif semiconducteur, à faible bruit en hyperfréquence, monté dans un boîtier.**

L'invention concerne un transistor hyperfréquence monté dans un boitier hermétique pour être utilisable et améliorer ses performances de façon optimum.

Pour diminuer le facteur de bruit d'un transistor (9) en hyperfréquences, il faut diminuer les dimensions géométriques de la grille. Mais le transistor change d'impédance et de fréquence maximale, et n'est plus utilisable en boitier (10, 11) et à l'impédance externe du circuit. Il faut le préadapter en montant une self (17, 20) entre sa grille, son drain et les connexions extérieures correspondantes. Chaque self est constituée par un fil métallique (17, 20), long et formant une épingle, soudé à l'intérieur du boîtier entre la métallisation (18) de grille et l'extrêmité interne (19) de sa connexion externe (13), ou entre la métallisation (21) de dralin et l'extrémité interne (22) de sa connexion externe (15).

Application aux amplificateurs hyperfréquences à faible bruit.

**FIG_2**

## DISPOSITIF SEMICONDUCTEUR A FAIBLE BRUIT EN HYPERFREQUENCE, MONTE DANS UN BOITIER

La présente invention concerne un dispositif semiconducteur constitué par un transistor hyperfréquence, fonctionnant en amplificateur faible bruit, encapsulé dans un boitier à cavité interne. Ce transistor hyperfréquence est adapté à une impédance externe normalisée, 50 ohms, en entrée et en sortie et il est donc utilisable dans une large gamme de fréquences sans réseau d'adaptation d'impédance externe: en effet il est préadapté à l'intérieur du boitier, et la préadaptation aux bornes de la puce de matériau semiconducteur permet d'avoir plus de gain et une plus grande largeur de bande qu'une adapatation externe, aux bornes du boitier, ainsi qu'un facteur de bruit plus faible.

La réalisation d'amplificateurs hyperfréquence, dans une gamme allant de 6 à 100 GHz par exemple, pose deux types de problèmes. D'une part, on ne sait pas, dans l'état actuel des techniques, faire de boitier étanche fonctionnant au delà de 25 GHz pour des amplificateurs à faible bruit, et cependant il est nécessaire que, pour être montés sur un satellite, un faisceau hertzien ou un matériel militaire, les amplificateurs hyperfréquences soient dans un boitier. A chaque bande de fréquence correspond un boitier adapté en impédence extérieure.

D'autre part, pour diminuer le bruit et augmenter le gain d'une puce de transistor hyperfréquence, il faut diminuer les dimensions de la grille, mais dans ce cas la fréquence optimale du transistor change, et passe par exemple de la bande 6 - 18 GHz à la bande 18 - 40 GHz: une puce ainsi modifiée n'est plus utilisable dans un boitier monté entre deux lignes 50 ohms à 12 GHz.

Pour remédier à ces inconvénients, l'invention propose une préadaptation d'une puce de transistor hyperfréquence à faible bruit directement à l'intérieur du boitier d'encapsulation, le circuit de préadaptation étant monté entre les plots métallisés de la puce du transistor et les extrémités internes des connexions extérieures du boitier. Puisque la diminution des dimensions de grille, pour diminuer le bruit, modifie l'impédance de transistor et la rapproche de celle du circuit ouvert, on corrige cette modification d'impédance en insérant à l'intérieur du boitier un réseau de préadaptation constitué par au moins une self entre le plot de grille ou de drain et la connexion externe correspondante.

C'est donc un objet de l'invention que d'obtenir, par préadaptation interne au boitier, un transistor hyperfréquence qui ait moins de bruit et plus de gain monté entre deux lignes 50 ohms. Etant adapté, l'amplificateur faible bruit a également plus de gain et une plus grande largeur de bande.

C'est un autre objet de l'invention que de pouvoir encapsuler une puce de transistor faible bruit, fonctionnant par exemple à 40 GHz, dans un boitier utilisable jusqu'à 25 GHz, puisqu'on ne sait pas actuellement faire de boitier étanche fonctionnant au-delà de 25 GHz.

Un perfectionnement à l'invention consiste à ajouter, à l'intérieur du boitier, un second réseau d'adaptation pour parvenir au voisinage du facteur de bruit minimum, connecté sur l'extrémité interne d'une connexion extérieure. Ce réseau, constitué par une self en série avec une capacité, améliore le gain s'il est connecté sur le drain ou diminue le bruit s'il est conecté sur la grille.

De façon plus précise l'invention consiste en un dispositif semiconducteur à faible bruit en hyperfréquences constitué par un transistor monté dans un boitier, muni d'une cavité interne et d'au moins deux connexions externes, la puce du transistor étant soudée sur une semelle métallique ou métallisée intérieure au boitier, et étant munie de métallisations de prises de contact sur ses électrodes de grille et de drain, ce dispositif semiconducteur étant caractérisé en ce qu'il est préadapté en impédance par au moins une self montée en série entre l'une des électrodes de grille ou de drain du transistor et la connexion externe qui lui correspond, cette self, interne au boitier, étant constituée par un fil ou ruban métallique, fixé entre une métallisation sur la puce du transistor et l'extrémité interne d'une connexion extérieure, et formant une épingle dont les deux brins sont sensiblement parallèles entre eux.

L'invention sera mieux comprise par la description plus détaillée qui suit maintenant d'un exemple d'application en liaison avec les figures jointes en annexe qui représentent:

- figure 1 : vue en plan d'une pastille de transistor hyperfréquence montée dans un boitier, selon l'art connu

- figure 2 : vue en plan d'une pastille de transistor hyperfréquence montée dans un boitier, selon l'invention

- figure 3 : schéma de préadaptation, variable avec la fréqueance, d'un fil de connexion à l'intérieur d'un boitier, selon l'invention

- figure 4 : courbes de gain et de facteur de bruit, en fonction de la fréquence pour un transistor de type MESFET préadapté selon l'invention

- figure 5 : courbes de gain associé au facteur de bruit minimum, en fonction de la fréquence pour un transistor de type MESFET préadapté selon l'invention

- figure 6 : courbes de gain, gain associé au facteur de bruit minimum, en fonction de la fréquence pour un transistor à hétéro-jonction de type TEGFET préadapté selon l'invention

- figure 7 : schéma électrique d'un perfectionnement à l'invention, par adaptation au voisinage du facteur de bruit minimum

- figure 8 : vue en plan d'une pastille de transistor hyperfréquence montée dans un boitier selon le perfectionnement de la figure 7

- figure 9 : courbes de gain associé au facteur de bruit minimum, en fonction de la fréquence, pour un transistor TEGFET selon le perfectionnement à l'invention.

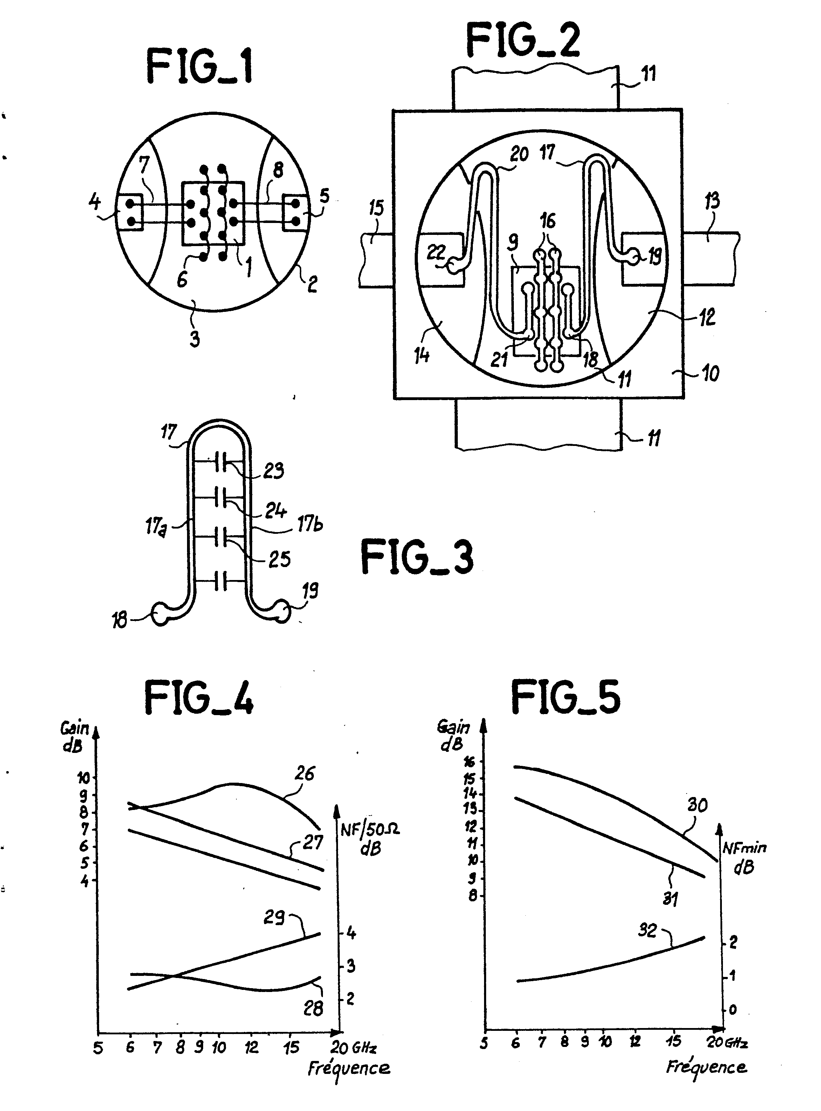

La figure 1, qui représente une vue en plan d'une pastille de transistor hyperfréquence montée dans un boitier, a pour objet de rappeler les règles de l'art connu. Si une pastille 1 de transistor hyperfréquence doit être montée dans un boitier symbolisé par un cercle 2, la pastille est généralement soudée sur une semelle métallique 3, et ses différentes électrodes de grille et de drain sont reliés à la semelle métallique 3 et aux connexions extérieures du boitier 4 et 5 par l'intermédiaire de fils ou de rubans métalliques. Sur la figure 1, la source du transistor est reliée à la semelle métallique 3 par des rubans 6, tandis que la grille est reliée à la connexion externe 4 par un ruban 7 et le drain relié à la connexion externe 5 par un ruban 8. Le montage peut être différent, mais ce qui importe est qu'il est bien connu que chaque fois que l'on monte une puce de transistor, le montage est disposé de telle façon que les fils ou les rubans de connexion 6, 7 et 8 soient le plus court possible, de façon à éviter les selfs parasites qui sont automatiquement créées par des longueurs de fils, dans le domaine des hyperfréquences.

L'invention, au contraire, crée des connexions entre les plots de grille et de drain de la puce du transistor qui soient de longueur telle qu'une self est créée, sur les plots des métallisations d'accès à la puce du transistor, et entre ces plots et les extrémités internes au boitier des connexions d'accès extérieures.

Lorsqu'on veut améliorer les performances en faible bruit d'un amplificateur fonctionnant dans le domaine des hyperfréquences, entre 6 et 40 GHz par exemple, et que cet amplificateur est monté à l'intérieure d'un boitier présentant une cavité interne, on sait qu'il faut diminuer les dimensions de grille du transistor, par exemple de 0,5 à 0,3 micron de longuer pour la grille, afin de diminuer le bruit, parce que le temps de transist de électrons dans la région de grille est plus court. Par conséquent les perte hyperfréquences sont moindres, et le gain augmente. De la même façon les grilles sont diminuées en largeur de 300 à 128 ou 64 microns, ce qui fait que la puce de transistor, ayant alors une configuration différente, travaille à une fréquence supérieure.

Mais des puces ainsi modifiées par diminution des dimensions de leur grille deviennent inutilisable dans un boitier monté sur lignes 50 ohms d'impédance extérieure, à cause de la modification dfes paramètres en S et du taux d'ondes stationnaires.

Pour caractériser les performances en hyperfréquence, les paramètres de réflexion en S sont utilisés. Le paramètre $S_{11}$ est le coefficient de réflexion à l'entrée, avec la sortie connectée sur une impédance de 50 $\Omega$ . Le paramètre $S_{22}$ est le coefficient de réflexion à la sortie avec l'entrée connectée sur une impédance de 50$\Omega$ . Ainsi des puces de transistor fonctionnant normalement entre 6 et 18 GHz modifiées pour avoir un faible bruit par diminution de leur grille, fonctionnent à 40 GHz et ne conviennent plus pour fonctionner à 12 GHz dans un boitier monté sur 2 lignes 50 ohms en entrée et en sortie.

Pour réaliser un amplificateur à faible bruit fonctionnant à 12 GHz par exemple, puisque c'est l'exemple qui a été choisi pour exposer l'invention, il faut préadapter la puce du transistor, sur les polots de la puce et à l'intérieur du boitier. Ainsi une adaptation d'impédance rend utilisable le transistor encapsulé, dans une bande de 6 à 18 GHz.

La préadaptation se fait par une self montée en série, sur au moins l'un des deux plots de grille ou de drain, ainsi que représenté en figure 2.

Celle-ci représente la partie centrale d'un boitier à cavité interne, dans lequel est encapsulée une pastille de transistor hyperfréquence, préadaptée selon l'invention.

Une pastille de transistor hyperfréquence 9, dont il n'est pas utile de donner le détail des métallisations de grille, de source et de drain, est montée à l'intérieur d'un boitier discret constitué par un cadre céramique 10, fixé sur une embase métallique 11. L'embase métallique 11 constitue un plan de masse à l'intérieur du boitier, et en déborde extérieurement de façon à constituer un moyen de fixation du boitier en même temps qu'une connexion d'accès extérieure des électrodes de source. A l'intérieur du boitier un épaulement isolant 12, en céramique par exemple, supporte une première connexion d'accès extérieure 13, et, symétriquement, un épaulment 14 en matière isolante supporte une seconde connexion d'accès extérieure 15. Les connexions d'accès extérieures 13 et 15 constituent des lignes adaptées en impédance à 50 ohms.

La métallisation de source du transistor 9 est connectée au plan de masse 11 par l'intermédiaire d'un ou plusieurs fils ou rubans métalliques 16. Le nombre de fils ou rubans et le nombre de points de soudure à la surface de la pastille du transistor 9 dépend de la configuration du transistor et de la diminution de l'inductance de source.

La liaison électrique entre la source et le plan de masse est la plus courte possible pour avoir un gain optimum. Mais, étant entendu que toute fraction de ligne 50 ohms qui ne sert à rien, si ce n'est qu'à franchir l'espace entre l'intérieur et l'éxtérieur du boitier, comme dans l'art connu dans la figure 1, fait tourner la phase et diminuer la bande passante du transistor en boitier, il faut donc supprimer ou adapter ces portions de lignes 50 ohms, essentiellement entre le plot de grille et le circuit extérieur d'une part et entre le plot de drain et le circuit extérieur d'autre part.

Il a été dit qu'en diminuant les dimensions en longueur et en largeur de la grille, on déplace les caractéristiques du transistor, et, sur l'abaque de Smith, sur laquelle l'impédance de 50 ohms est au centre du cercle, on se rapproche d'un circuit ouvert : il est donc nécessaire pour préadapter la puce d'un transistor ainsi modifié pour avoir un faible bruit et un grand gain, d'ajouter une self en série sur la grille et/ou le drain, de façon à se rapprocher de l'adaptation au facteur de bruit minimum pour l'entrée et à 50 ohms pour la sortie.

Pour au moins l'une des deux électrodes, - mais de préférence pour les deux, - la self de préadaptation interne de grille est constituée par un fil de liaison 17 qui constitue une épingle entre le plot de grille 18 sur la puce du transistor et l'éxtrémité 19 de la partie interne de la connexion extérieure 13. De la même façon la self de préadaptation de drain est constituée par un fil 20 qui forme une épingle entre le plot de métallisation 21 de drain sur la puce du transistor et l'extrémité interne 22 de la connexion d'accès extérieure.

Il est important que ces fils, qui sont longs, contrairement à ce qu'enseigne la pratique dans le domaine des hyperfréquences, forment une épingle dans laquelle deux brins du fil sont sensiblement dans le même plan, et sensiblement parallèles entre eux.

En effet, comme cela est montré sur la figure 3, si un fil de connexion 17, soudé par ses deux extrémités en 18 et en 19, est parcouru par une onde hyperfréquence, et si ce fil 17 forme une épingle dont les deux brins 17a et 17b sont sensiblement parallèles entre eux, il se crée un effet capacitif symbolisé sur la figure 3 par de petits condensateurs 23, 24, 25.... Mais cet effet capacitif n'est pas fixe, et il évolue en fonction de la fréquence d'utilisation du transistor. Ainsi la self présentée par chacun des fils 17 et 20 à l'intérieur de boitier du transistor n'est pas fixe mais diminue lorsque la fréquence augmente. Ceci permet d'élargir la bande de fréquence dans laquelle le transistor a un gain suffisant, et de façon plus générale ce montage, outre qu'il adapte l'impédance d'entrée et l'impédance de sortie du transistor encapsulée selon l'invention, augmente le gain.

Une puce de transistor hyperfréquence, modifiée pour obtenir un faible bruit, et montée dans un boitier selon le schéma de l'invention, permet donc d'obtenir:
- un meilleur facteur de bruit, puisque la pastille a été adaptée dans ce sens,
- une augmentation de gain par la préadaptation de la pastille à l'intérieur de boitier, et non pas à l'extérieur,
- une augmentation de la largeur de bande puisque les parties des lignes de 50 ohms qui relient la puce à l'extérieure du boitier sont préadaptées, par les selfs 17 et 20.

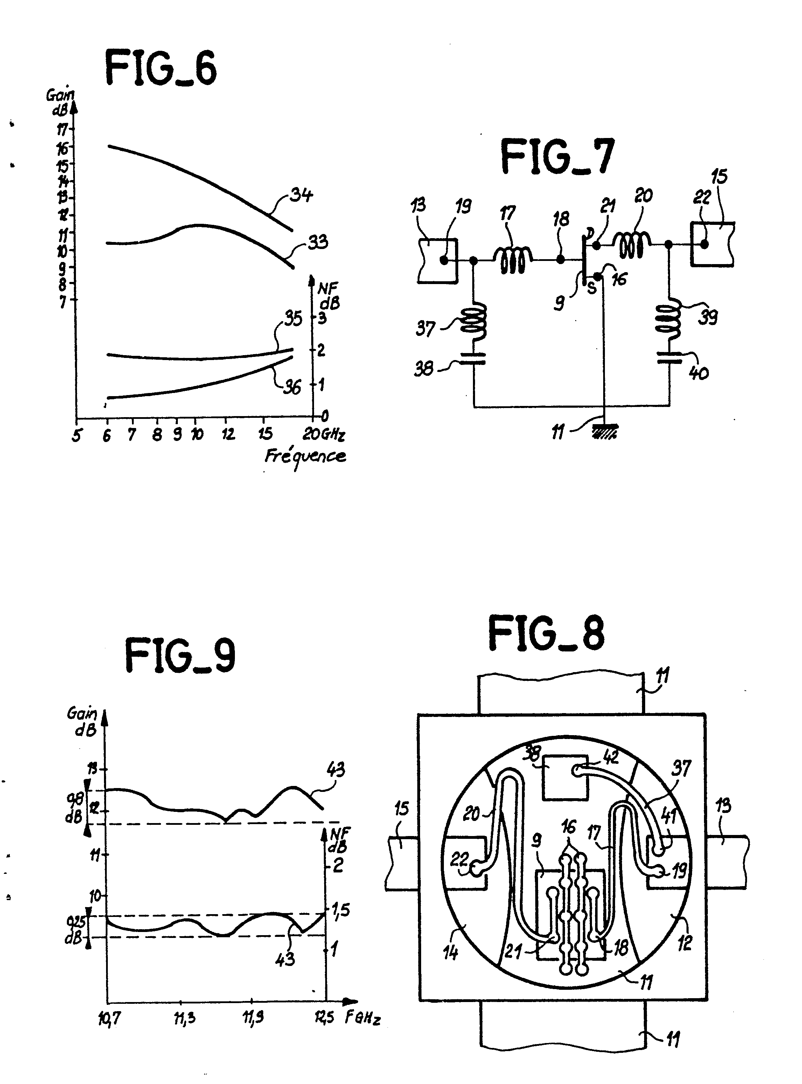

Les figures 4 et 5 mettent en évidence des améliorations apportées par le branchement d'une puce selon l'invention. En figure 4, les courbes représentent le gain sur 50 ohms et le facteur de bruit NF sur 50 ohms également en fonction de la fréquence, dans un bande de 6 à 18 GHz. La courbe 26 montre qu'un transistor MESFET préadapté à l'intérieur de son boitier a un gain compris entre 7 et 9,5 dB environ, entre 6 et 18 GHz, tandis qu'un transistor selon l'art connu, qui n'est pas préadapté, a un gain qui, selon la courbe 27, chute de 7 à 3,5 dB environ. Simultanément, et dans la même gamme de fréquence, un transistor préadapté selon l'invention a comme le montre la courbe 28 un facteur de bruit qui est sensiblement constant entre 2,2 dB et 2,7 dB, tandis qu'un transistor selon l'art connu, non préadapté, a un facteur de bruit qui croit de 2,3 dB jusque presque 4 dB. Si, sur la figure 5, on considère maintenant le gain associé au facteur de bruit minimum pour chaque fréquence, on constate que, entre un transistor préadapté selon l'invention, dont la courbe de gain associé au facteur de bruit est représenté en 30, et un transistor selon l'art connu, dont la courbe est représenté en 31, il y a environ 2 dB de gain d'écart, sur toute la gamme de 6 à 18 /GHz.

Les courbes des figures 4 et 5 sont relatives à un transistor hyperfréquence de type MESFET ou plus exactement dont le corps de la puce est constitué de façon homogène par des couches de matériau telles que GaAs, le silicium étant hors de portée de l'invention dans le domaine d'hyperfréquence considéré. En fait le montage selon l'invention préadapte mieux les transistors fabriqués avec des hétéronjonctions entre AlGa As et GaAs, c'est-à-dire les transistors à gaz bidimentionnel d'électrons tel que TEGFETS, parce que l'impédance d'un tel transistor, au facteur de bruit minimum, est plus proche de 50 ohms pour GaAs sur AlGa As que pour un MESFET sur GaAs. Ceci est dû à la constitution du matériau.

Cette meilleure préadaptation est mise en évidence sur la figure 6, relative à un TEGFET: la courbe 33 donne le gain sur 50 ohms externes entre 6 et 18 GHz, la courbe 34 donne le gain associé au facteur de bruit minimum, la courbe 35 donne le facteur de bruit sur 50 ohms et la courbe 36 donne le facteur de bruit minimum. Dans l'ensemble on voit qu'il y a toujours une amélioration de 1 à 2 dB sur le gain ou le gain associé, par rapport à un MESFET et une diminution de l'ordre de 1 dB du facteur de bruit.

Un perfectionnement peut être apporté à l'invention, en ajoutant un autre réseau de préadaptation à l'intérieur du boitier, dans la limite où les dimensions de la cavité interne d'un boitier le permettent. Ce perfectionnement consiste à adapter le transistor au voisinage du facteur de bruit minimum, par conséquent dans une bande plus étroite telle que 10, 7 à 12,5 GHz et il peut être facilement réalisé selon le schéma électrique de la figure 7.

Sur cette figure, un transistor 9 ayant une source reliée à la masse par un ruban 16, une grille reliée à une impédance extérieure 13 au moyen d'une self 17 connectée entre la métallisation 18 de grille du transistor et une soudure en 19 sur l'impédance 13, et un drain relié à une impédance extérieure 15 par l'intermédiaire d'une self 20 connectée entre la métallisation 21 et une soudure 22 sur l'impédance extérieure, représente le schéma de l'invention de base telle qu'elle a été décrite jusqu'à présent.

Un premier perfectionnement à cette invention, qui permet de diminuer le bruit, consiste à monter, entre le point de soudure 19 sur l'impédance 13 de grille et la masse, un circuit composé d'une self 37 en série avec une capacité 38. A titre d'exemple la self 37 peut avoir une valeur de l'ordre de 1 nH et la capacité 38 d'une valeur de l'ordre de 10 pF.

Un second perfectionnement qui permet d'augmenter le gain du transistor consiste à monter, symétriquement par rapport au précédent réseau, entre le point de soudure 22 sur l'impédance 15 de drain et la masse, un circuit composé par une self 39 en série avec une capacité 40.

La réalisation de ce perfectionnement à l'invention est représenté en figure 8, qui reprend les éléments essentiels de la figure 2, mais dans laquelle un pavé de capacité 38 est fixé à l'intérieur du boitier sur la semelle métallique 11, ce qui met donc une armature de la capacité à la masse. Un fil ou un ruban 37, qui contourne le fil ou le ruban 17 de grille, est fixé entre un point de soudure 41 sur l'impédance externe 13 et un point de soudure 42 sur la face supérieure de la capacité 38.

Le même montage peut être réalisé sur le drain du transistor, mais c'est essentiellement une question de géométrie du boitier d'encapsulation, qui permet selon la place disponible de monter un (ou deux) circuit(s) selon l'invention.

La figure 9 donne les courbes de gain associé et de facteur de bruit en fonction de la fréquence pou un transistor TEGFET encapsulé dans un boitier, et muni du dispositif d'adaptation interne et de son perfectionnement pour améliorer le bruit, au moyen de réseau de self 37 et de capacité 38. La courbe 43 donne l'évolution du gain associé au bruit minimum dans la gamme de 10,7 à 12,5 GHz, et on voit que cette courbe est relativement plate entre 11,7 et 12,5 dB, c'est à dire qu'elle est comprise dans une enveloppe de 0,8 dB de variation, tandis que la courbe 43 donne le gailn minimum associée, compris dans une enveloppe de 0,25 dB, entre 1,2 et 1,45 dB. Par rapport aux courbes de la figure 6, la différence à la fréquence de bruit minimum n'est pas extrêmement importante, mais dans la gamme de fréquence pour laquelle le transistor a reçu ce perfectionnement les courbes sont plus plates, ce qui présente un intérêt pour le matériel fabriqué avec un amplificateur encapsulé dans un boitier, selon l'invention, sans adaptation extérieure.

L'invention est donc appliquée aux transistors encapsulés dans des boitiers à cavité, utilisés en amplificateur hyperfréquence dans tous les matériels tels que les télécommunications, les radars ou les faisceaux hertziens. Elle est précisée par les revendications suivantes.

## Revendications

1. Dispositif semiconducteur à faible bruit en hyperfréquences constitué par un transistor (9) monté dans un boitier (10), muni d'une cavité interne et d'au moins deux connexions externes (13, 15), la puce du transistor (9) étant soudée sur une semelle métallique (11) intérieure au boitier, et étant munie de métallisations de prises de contact sur ses électrodes de grille et de drain, ce dispositif semiconducteur étant caractérisé en ce qu'il est préadapté en impédance par au moins une self montée en série entre l'une des électrodes de grille ou de drailn du transistor et la connexion externe qui lui correspond, cette self, interne au boitier, étant constituée par un fil ou ruban métallique (17), fixé entre une métallisation (en 18) sur la puce du transistor (9) et (en 19) l'extrémité interne d'une connexion extérieure (13), et formant une épingle dont les deux brins (17 a et 17 b) sont sensiblement parallèles entre eux.

2. Dispositif semiconducteur selon la revendication 1, caractérisé en ce qu'une self (17) est connectée entre la métallisation (18) de grille et l'extrémité interne (19) de la connexion (13) extérieure de grille.

3. Dispositif semiconducteur selon la revendication 1, caractérisé en ce qu'une self (20) est connectée entre la métallisation (21) de drain et l'extrémité interne (22) de la connexion (15) externe de drain.

4. Dispositif semiconducteur selon la revendication 1, caractérisé en ce que la valeur de la self (13), qui relie une métallisation (18) sur la puce de transistor (9) et l'extrémité interne (19) de la connexion (13) extérieure correspondante, est variable avec la fréquence d'utilisation du transistor (9).

5. Dispositif semiconducteur selon la revendication 1, caractérisé en ce qu, en vue de diminuer encore le bruit, il comporte en outre un réseau d'adaptation, interne au boitier, constitué par une self (37) et une capacité (38) montées en série, la self (37) étant reliée à l'extrémité interne (19) de la connexion (13) extérieure de grille, et la capacité étant reliée à la masse (11).

6. Dispositif semiconducteur selon la revendication 1, caractérisé en ce que, en vue d'améliorer le gain, il comporte en outre un réseau d'adaptation, interne au boitier, constitué par une self (39) et une capacité (4) montées en série, la self (39) étant reliée à l'extrémité interne (22) de la connexion (15) extérieure de drain, et la capacité étant reliée à la masse (11).

FIG_1

FIG_2

FIG_3

FIG_4

FIG_5

0 274 941

FIG_6

FIG_7

FIG_9

FIG_8

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | FR-A-2 507 017  (RTC)<br>* Figure 3; page 10, ligne 29 - page 11, ligne 4 * | 1 | H 01 L  23/56 |
| A | | 2,3,5,6 | |
| Y | EP-A-0 174 457  (NEC)<br>* Figures 5,8; revendications 1,5 * | 1 | |
| A | | 2,3 | |
| A | FR-A-2 231 114  (MITSUBISHI)<br>--- | | |
| A | PATENT ABSTRACTS OF JAPAN, vol. 6, no. 47 (E-99)[925], 26 mars 1982; & JP-A-56 162 858 (NIPPON DENKI K.K.) 15-12-1981<br>--- | | |
| A | FR-A-2 529 013  (PHILIPS) | | |

DOMAINES TECHNIQUES RECHERCHES (Int. Cl.4)

H 01 L

Le présent rapport a été établi pour toutes les revendications

| Lieu de la recherche | Date d'achèvement de la recherche | Examinateur |
|---|---|---|
| LA HAYE | 22-03-1988 | DE RAEVE R.A.L. |

EPO FORM 1503 03.82 (P0402)